# FASCICULE DE BREVET EUROPEEN

(11) **EP 3 368 704 B1**
(45) Date de publication et mention de la délivrance du brevet: **24.02.2021**
(21) Numéro de dépôt: 16809928.1
(22) Date de dépôt: 25.10.2016
(51) Int. Cl.: C23C 14/35, H01J 37/32, H05H 1/46, C23C 14/06, H01J 37/34

(54) **DISPOSITIF POUR LA FABRICATION D'UNE COUCHE EN CARBONE AMORPHE PAR PLASMA A LA RESONANCE CYCLOTRON ELECTRONIQUE**
VORRICHTUNG ZUR HERSTELLUNG EINER AMORPHEN KOHLENSTOFFSCHICHT DURCH ELEKTRONEN-ZYKLOTRON-RESONANZ-PLASMA
DEVICE FOR PRODUCING AN AMORPHOUS CARBON LAYER BY ELECTRON CYCLOTRON RESONANCE PLASMA

(30) Priorité: 27.10.2015 FR 1560224
(43) Date de publication de la demande: 05.09.2018
(73) Titulaire: Commissariat à l'Énergie Atomique et aux Énergies Alternatives, 75015 Paris (FR)
(72) Inventeur: DELAUNAY, Marc, 38240 Meylan (FR); GHIS, Anne, 38400 Saint Martin D'Heres (FR)
(74) Mandataire: Cabinet Camus Lebkiri
(86) Numéro de dépôt international: PCT/FR2016/052763
(87) Numéro de publication internationale: WO 2017/072434

(56) Documents cités:
- EP-A- 0 148 504
- EP-A1- 0 283 519
- EP-A2- 0 778 608
- WO-A1-2015/145486
- FR-A1- 2 774 251
- JP-A- S62 224 686

## Description

### DOMAINE TECHNIQUE

La présente invention concerne un dispositif pour la fabrication d'une couche en carbone amorphe par plasma à la résonance cyclotron électronique.

### ETAT DE LA TECHNIQUE ANTERIEUR

Le dépôt de couches de carbone par plasma à la résonance cyclotron électronique est connu de l'art antérieur. Ainsi, le document FR2774251 décrit un dispositif pour le dépôt de carbone par plasma à la résonance cyclotron électronique. Ce dispositif permet de déposer du carbone par dépôt physique en phase vapeur (également appelé PVD pour « Physical Vapor Déposition ») en pulvérisant une cible de carbone grâce à un plasma à la résonance cyclotron électronique (également appelé plasma RCE). Les plasmas RCE présentent en effet l'intérêt de pouvoir être générés d'une façon autonome sans filament ni cathode, à partir d'une zone de résonance cyclotron électronique qui génère des électrons énergétiques qui ionisent un gaz injecté dans une chambre plasma de façon à produire un plasma. Ce plasma diffuse suivant un faisceau de lignes de champ magnétique. Le faisceau est intercepté par la cible de carbone à pulvériser. Des atomes de carbone sont alors pulvérisés de la cible qui est polarisée négativement et ils atteignent un substrat sur lequel ils se déposent.

Toutefois, ces dispositifs de l'art antérieur sont très volumineux et le porte-substrat est éloigné du plasma ce qui implique des vitesses de dépôt très lentes. Par ailleurs, l'homogénéité des couches n'est obtenue que grâce à des mouvements de translation/rotation du support pendant le dépôt, ce qui implique des dispositifs très sophistiqués.

D'autres solutions ont alors été mises en œuvre pour rapprocher le porte-substrat. Par exemple dans le document US2005/0145339, le porte-substrat est placé dans l'axe du plasma mais le substrat est alors impacté par les particules du plasma qui peuvent détériorer le substrat et la couche déposée. De même, le document EP 0 283 519 A1 décrit un dispositif convenant à la mise en œuvre de la fabrication d'une couche de carbone amorphe.

### EXPOSE DE L'INVENTION

L'invention vise à remédier aux inconvénients de l'état de la technique en proposant un dispositif pour la fabrication d'une couche élastique de carbone amorphe par plasma à la résonance cyclotron électronique qui permette de produire des couches de carbone amorphe de faible épaisseur, continues, homogènes, élastiques, dont le taux de liaison sp3 est supérieur à 20%, et sur tout type de substrat. L'invention est définie par les adjointes revendications.

Pour ce faire est proposé, selon un premier aspect de l'invention, un dispositif pour la fabrication d'une couche en carbone amorphe par plasma à la résonance cyclotron électronique, le dispositif comportant :
- une chambre plasma;
- des moyens d'amenée d'un gaz dans la chambre plasma,
- un miroir magnétique de confinement,
- un guide d'onde inséré dans la chambre plasma, le guide d'onde s'étendant suivant un axe de référence;
- des moyens d'injection d'une onde électromagnétique micro-onde agencés pour injecter une onde électromagnétique micro-onde dans la chambre plasma à l'aide du guide d'onde;
- des moyens de génération d'un champ magnétique dans la chambre plasma, les moyens d'injection et les moyens de génération étant configurés pour former une zone de résonance cyclotron électronique dans la chambre plasma, les moyens de génération du champ magnétique étant en outre configurés pour créer un faisceau de lignes de champ magnétique le long desquelles un plasma est diffusé, le plasma s'étendant suivant l'axe de référence, le plasma présentant un bord;
- une cible en carbone à pulvériser ;
- un porte-substrat agencé pour porter un substrat ;

Caractérisé en ce que :
- la cible est disposée parallèlement à l'axe de référence et à une distance de l'axe de référence comprise entre R_{cible}/2 et R_{cible}, où R_{cible} est la distance, au niveau de la cible, entre le bord du plasma et l'axe de référence, et en ce que,
- le dispositif comporte en outre un écran disposé entre le guide d'onde et le porte-substrat, l'écran s'étend perpendiculairement à l'axe de référence et arrêtant localement les particules de plasma susceptibles d'impacter le substrat,
- le porte-substrat est disposé parallèlement à l'axe de référence et à une distance de l'axe de référence supérieure à R_{cible} telle que le substrat soit disposé hors du plasma,
- la cible et le porte-substrat sont disposés l'un en face de l'autre.

En fonctionnement, les moyens de génération d'un champ magnétique et les moyens d'injection d'une onde électromagnétique micro-onde permettent la création d'une zone de résonance cyclotron électronique, qui génère des électrons énergétiques, qui ionisent le gaz injecté dans la chambre plasma de façon à produire un plasma. Les moyens de génération du champ magnétique génèrent, dans le miroir magnétique de confinement, un faisceau de lignes de champ magnétique le long desquelles le plasma est diffusé. Ce faisceau de lignes de champ magnétique s'étend suivant le même axe de référence que le guide d'onde. Le bord du faisceau de lignes de champ magnétique est à une distance de l'axe de référence égale à R. Cette distance R peut varier en fonction de la section du faisceau de lignes de champ magnétique au niveau de laquelle on se trouve.

Le fait de positionner la cible à une distance de l'axe de référence comprise entre R_{cible}/2 et R_{cible} permet de ne pas trop perturber le plasma tout en enfonçant suffisamment la cible dans le plasma pour qu'elle reçoive suffisamment d'ions pour être pulvérisée sur toute sa surface.

Disposer la cible parallèlement à l'axe de référence permet de ne pas perturber le plasma.

Disposer la cible et le substrat l'un en face de l'autre permet à la majorité des atomes de carbone qui sont arrachés de la cible d'aller se déposer sur le substrat.

Le fait que l'écran s'étende perpendiculairement à l'axe de référence permet à l'écran de protéger efficacement le substrat des impacts du plasma sans pour autant gêner le déplacement des atomes de carbone de la cible vers le substrat.

Le fait de disposer le porte substrat sensiblement parallèlement à l'axe de référence permet de limiter les impacts du plasma sur le substrat.

En disposant le porte substrat hors du plasma, on limite ainsi encore les impacts du plasma sur le substrat.

L'écran permet de protéger le substrat puisqu'il intercepte partiellement les lignes de champ magnétique. L'écran permet donc de protéger le substrat et la couche de carbone amorphe déposée dessus, du flux d'électrons et d'ions du plasma.

Le dispositif selon l'invention peut également présenter une des caractéristiques ci-après prises individuellement ou selon toutes les combinaisons techniquement possibles.

Avantageusement, l'écran est constitué d'un matériau amagnétique, de façon à ce que l'écran ne perturbe pas le faisceau de lignes de champ magnétique.

Avantageusement, l'écran est constitué d'un matériau conducteur électriquement, de façon à évacuer les charges du plasma.

Avantageusement, le dispositif comporte des moyens de polarisation de la cible agencé pour polariser électriquement la cible.

Avantageusement, le dispositif comporte en outre un substrat en matériau organique, disposé sur le porte-substrat, ce qui permet de déposer la couche en carbone amorphe sur un substrat en matériau organique, de façon à pouvoir le dissoudre plus facilement par la suite si besoin. Le matériau organique est de préférence un polymère. Le polymère est par exemple du PMMA. En effet, le dispositif est particulièrement avantageux car il permet le dépôt de la couche en carbone amorphe sur des substrats qui ne sont pas chauffés, qui ne sont pas polarisés électriquement et qui ne sont pas impactés par les particules du plasma, de sorte qu'on peut utiliser des substrats fragiles, par exemple en polymère, ce qui n'était pas le cas avec les dispositifs de l'art antérieur.

Avantageusement, les moyens d'amenée sont configurés pour injecter un gaz noble dans la chambre plasma. Ce gaz noble est de préférence de l'argon ou du krypton.

Avantageusement, la cible est disposée dans une zone du miroir de confinement au niveau de laquelle le champ magnétique B est minimum

### BREVES DESCRIPTION DES FIGURES

D'autres caractéristiques et avantages de l'invention ressortiront à la lecture de la description détaillée qui suit, en référence aux figures annexées, qui illustrent :
- La figure 1, une représentation schématique d'un dispositif selon un mode de réalisation de l'invention ;
- La figure 2, une autre représentation schématique du dispositif de la figure 1 ;
- La figure 3a, une observation au microscope électronique à balayage (MEB) d'une couche en carbone amorphe obtenue dans le dispositif des figures 1 et 2 et reportée sur un circuit électronique;
- La figure 3b, une autre observation au microscope électrique à balayage de la couche de la figure 3a sous laquelle une bulle de gaz a été emprisonnée.

Pour plus de clarté, les éléments identiques ou similaires sont repérés par des signes de références identiques sur l'ensemble des figures.

### DESCRIPTION DETAILLEE D'AU MOINS UN MODE DE REALISATION

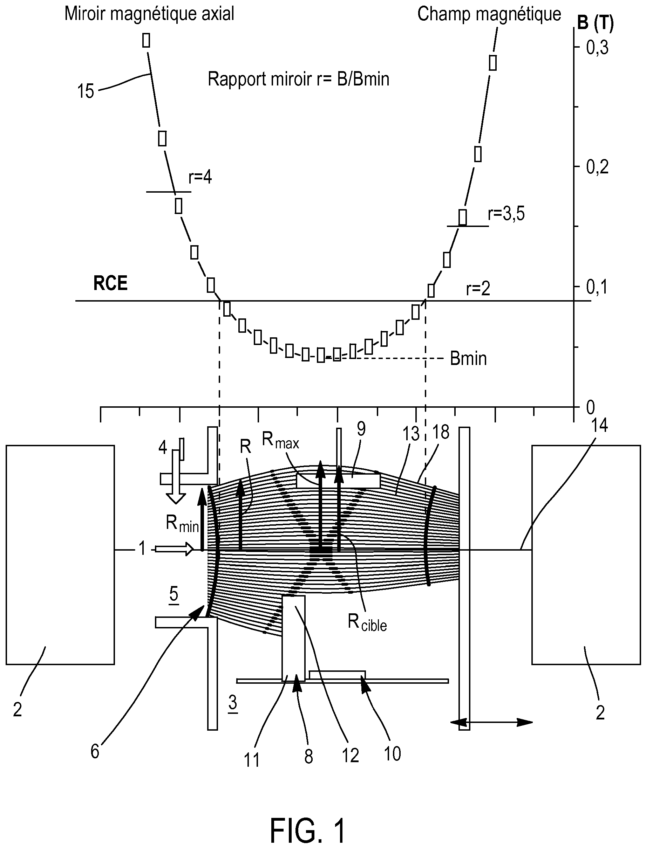

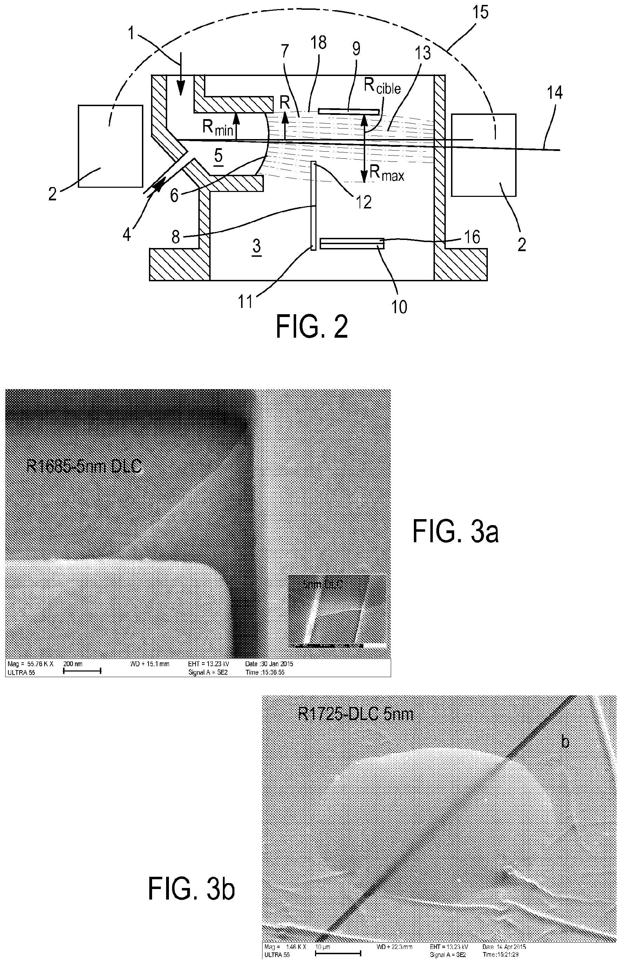

Les figures 1 et 2 représentent un dispositif selon un mode de réalisation de l'invention. Ce dispositif comporte :
- une chambre plasma 3;
- des moyens d'amenée 4 d'un gaz dans la chambre plasma. Les moyens d'amenée 4 sont de préférence configurés pour amener, dans la chambre plasma, un gaz noble à ioniser de façon à former un plasma. Ce gaz noble est de préférence de l'argon ou du krypton ;
- un miroir magnétique 15 de confinement. Le miroir magnétique 15 comporte de préférence deux solénoïdes ou deux blocs d'aimants permanents;
- des moyens d'injection 1 d'une onde électromagnétique micro-onde. Ces moyens d'injection 1 comportent en particulier un générateur d'onde électromagnétique micro-onde. Cette onde électromagnétique micro-onde présente de préférence une fréquence de 2.45 GHz ;
- un guide d'onde 5 inséré dans la chambre plasma 3 et à travers lequel les moyens d'injection 1 injectent l'onde électromagnétique micro-onde dans la chambre plasma 3. La partie du guide d'onde insérée dans la chambre plasma s'étend suivant un axe de référence. La partie du guide d'onde insérée dans la chambre plasma présente une symétrie par rapport à l'axe de référence 14;
- des moyens de génération 2 d'un champ magnétique dans la chambre plasma 3. Ces moyens de génération 2 comportent de préférence des aimants permanents ou des solénoïdes.

Les moyens de génération 2 et les moyens d'injection 1 sont aptes à créer au moins une zone de résonance cyclotron électrique 6, également appelée zone RCE, dans la chambre plasma 3 ou dans le guide d'onde, et plus précisément dans le miroir magnétique 15. Cette zone de résonance cyclotron électronique 6 permet d'accélérer les électrons qui vont ioniser le gaz injecté, par impact électronique et générer ainsi un plasma.

Les moyens de génération du champ magnétique 2 sont en outre configurés pour créer, dans le miroir magnétique de confinement 15, un faisceau 13 de lignes de champ magnétique le long desquelles le plasma 7 créé est diffusé. Le faisceau 13 de lignes de champ magnétique est issu de la zone RCE. Le faisceau de lignes de champ magnétique s'étend suivant l'axe de référence 14. Le plasma s'étend donc également suivant l'axe de référence 14.

Le faisceau de lignes de champ magnétique peut présenter une section cylindrique ou rectangulaire. Le faisceau est en général biconvexe. Le faisceau de lignes de champ magnétique, et donc le plasma, présentent un bord 18 qui délimite le faisceau de lignes de champ magnétique et donc le plasma. Ce bord 18 est éloigné de l'axe de référence d'une distance R. Cette distance R varie en fonction du point de l'axe de référence au niveau duquel on se trouve. En effet, comme le bord du plasma peut être plus ou moins convexe, la distance R peut varier entre une distance maximale Rₘₐₓ, et une distance minimale Rₘᵢₙ.

Le plasma restant localisé sur le faisceau 13 de lignes de champ magnétique, il a donc une forme bien définie, et il a le même axe et les mêmes dimensions que le faisceau 13.

Le dispositif comporte également une cible 9 en carbone à pulvériser. Les ions du plasma viennent heurter la cible 9 et éjectent des atomes de carbone. Le dispositif peut comporter également des moyens de polarisation de la cible agencés pour polariser, de préférence négativement, la cible 9.

Le dispositif comporte également un porte-substrat 10 apte à porter un substrat 16 sur lequel on veut déposer une couche en carbone. Les atomes de carbone éjectés de la cible 9 viennent se déposer sur le substrat 16 pour former une couche de carbone amorphe.

La cible 9 est disposée en bord du plasma, au lieu d'être disposée dans l'axe du plasma. Plus précisément, la partie du bord 18 du plasma qui est située au niveau de la cible se situe à une distance de l'axe de référence 14 égale à R_{cible}. Lorsque le faisceau de lignes de champ magnétique présente une section cylindrique, R_{cible} est donc le rayon de la section transversale du faisceau de lignes de champ magnétique au niveau de laquelle la cible est placée. Lorsque le faisceau de lignes de champ magnétique présente une section rectangulaire, 2*R_{cible} représente donc la hauteur de la section transversale du faisceau de lignes de champ magnétique au niveau de laquelle la cible est placée. La cible 9 est disposée à une distance de l'axe de référence comprise entre R_{cible}/2 et R_{cible}.

La cible est de préférence disposée dans le miroir de confinement, avantageusement là où le champ magnétique B est minimum.

La cible est de préférence disposée sensiblement parallèlement à l'axe de référence.

Le porte-substrat 10 est disposé face à la cible 9 sur un bord opposé du plasma. Le porte-substrat 10 est de préférence disposé sensiblement parallèlement à la cible. Le porte-substrat est de préférence disposé hors du plasma. Pour cela, le porte-substrat 10 est disposé à une distance de l'axe de référence supérieure à R_{cible}.

Afin de protéger le substrat des impacts du plasma, un écran 8 est disposé devant le porte-substrat 10. L'écran 8 est disposé entre le guide d'onde 5 et le porte-substrat 10. L'écran 8 est de préférence formé d'une plaque, par exemple plate. L'écran comporte de préférence une première extrémité 11 sensiblement alignée avec le porte-substrat. L'écran comporte une deuxième extrémité 12 enfoncée dans le plasma pour arrêter localement les particules du plasma susceptibles d'impacter le substrat. Cette disposition permet ainsi de placer le porte-substrat à une distance faible de la cible tout en évitant sa détérioration par impacts du plasma. L'écran présente de préférence une largeur sensiblement égale à la largeur du porte-substrat.

L'écran 8 est de préférence constitué d'un matériau amagnétique afin de ne pas perturber le champ magnétique dans la chambre plasma. En outre, l'écran 8 est de préférence constitué d'un matériau conducteur électriquement afin de participer à l'évacuation des charges de la chambre plasma.

Le dispositif selon l'invention est particulièrement avantageux en ce qu'il permet de fabriquer des couches de carbone amorphe de faible épaisseur, c'est-à-dire d'épaisseur comprise entre 1 et 5 nm, continues, homogènes et élastiques, ce qui n'était pas le cas des dispositifs de l'art antérieur. En effet, le dispositif permet d'obtenir des couches de carbone présentant des taux de liaison sp3 supérieures à 20% et donc des modules d'Young d'environ 200 GPa. En outre, il permet de réaliser de telles couches sans avoir recours à une méthode de pulvérisation par faisceau d'ions, sans chauffer le substrat et sans le polariser. On peut donc déposer la couche de carbone amorphe sur tout type de substrat et notamment sur des substrats en polymère. On peut ainsi notamment déposer une couche de carbone sur des substrats en plastique, polyméthacrylate de méthyle (PMMA), OLED (pour « Organic Light Emitter Diode »).

Les figures 3a et 3b représentent ainsi une couche de carbone amorphe reportée sur un circuit électronique et réalisée dans un dispositif semblable à celui des figures 1 et 2. Pour réaliser cette couche de carbone amorphe, l'onde électromagnétique micro-onde injectée par les moyens d'injection présentait une fréquence de 2.45 GHz et une puissance de 282 W. La résonance cyclotron électronique a eu lieu lorsque le champ magnétique B créé par les moyens de générateur était égal à 0.0875 T. Le gaz injecté dans la chambre plasma par les moyens d'amenée était du krypton injecté à une pression de 5.10⁻⁴ mbar. La cible en carbone était polarisée à -402V et 0.1A. Le dépôt de carbone a été effectué pendant 12 min, ce qui a permet d'obtenir une couche de carbone amorphe de 5 nm d'épaisseur. La vitesse de dépôt était donc de 0.42 nm/mn. Le champ magnétique présentait un minimum à 0.05T.

Le rayon de Larmor des électrons pour deux énergies cinétiques transverses Eₑ a été calculé. Les valeurs obtenues sont les suivantes :

| Eₑ | B= 0.05T | B=0.0875 T |
|---|---|---|
| 1eV | 0.066mm | 0.038mm |
| 100eV | 0.6mm | 0.38mm |

Les électrons ont donc été accélérés dans la zone de résonance cyclotron électronique et ont diffusé le long des lignes de champ magnétique sur des trajectoires hélicoïdales avec des rayons de Larmor de faible dimension, c'est-à-dire inférieur au millimètre.

Une observation au microscope électronique à transmission (MET) de la couche de carbone obtenue permet de confirmer qu'elle est bien amorphe sans cristallisation. Une analyse de cette couche de carbone amorphe par spectrométrie photoélectronique X (également appelée XPS pour « X-Ray photoelectron spectrometry ») indique que la couche de carbone présente un taux de liaisons sp3 de 25%, ce qui correspond à un module d'Young de 200 GPa environ. L'élasticité de la couche de carbone est confirmée par la figure 3b sur laquelle on voit qu'on peut emprisonner une bulle d'air sous la couche de carbone sans que cette couche ne se fissure.

Naturellement, l'invention n'est pas limitée aux modes de réalisations décrits en référence aux figures et des variantes pourraient être envisagées sans sortir du cadre de l'invention.

Les applications potentielles de ces couches de carbone amorphe sont d'une part la réalisation de MEMS (Micro Electro Mechanical System), de CMUT (Capacitive Micromachined Ultrasonic Transducer) et de microrésonateurs à memebrane suspendue, en particulier par report de couches, et d'autre part le packaging de dispositifs organiques (type OLED), la protection de dispositifs en milieu agressif (acide, base...) et l'étanchéité de dispositifs en présence de gaz léger (hydrogène hélium).

## Revendications

1. Dispositif pour la fabrication d'une couche en carbone amorphe par plasma à la résonance cyclotron électronique, le dispositif comportant :
- une chambre plasma (3);
- des moyens d'amenée d'un gaz (4) dans la chambre plasma (3),
- un miroir magnétique (15) de confinement,
- un guide d'onde (5) inséré dans la chambre plasma (3), le guide d'onde (5) s'étendant suivant un axe de référence (14);
- des moyens d'injection (1) d'une onde électromagnétique micro-onde agencés pour injecter une onde électromagnétique micro-onde dans la chambre plasma (3) à l'aide du guide d'onde (5);
- des moyens de génération (2) d'un champ magnétique dans la chambre plasma (3), les moyens d'injection (1) et les moyens de génération (2) étant configurés pour former une zone de résonance cyclotron électronique (6) dans la chambre plasma (3), les moyens de génération (2) du champ magnétique étant en outre configurés pour créer un faisceau (13) de lignes de champ magnétique le long desquelles un plasma est diffusé, le plasma s'étendant suivant l'axe de référence (14), le plasma présentant un bord;
- une cible (9) en carbone à pulvériser ;
- un porte-substrat (10) agencé pour porter un substrat ;
**Caractérisé en ce que** :
- la cible (9) est disposée parallèlement à l'axe de référence et à une distance de l'axe de référence comprise entre R_{cible}/2 et R_{cible}, où R_{cible} est la distance, au niveau de la cible, entre le bord du plasma et l'axe de référence, et **en ce que**
- le dispositif comporte en outre un écran (8) disposé entre le guide d'onde (5) et le porte-substrat (10), l'écran (8) s'étendant perpendiculairement à l'axe de référence (14) et arrêtant localement les particules de plasma susceptibles d'impacter le substrat;
- le porte-substrat (10) est disposé parallèlement à l'axe de référence (14) et à une distance de l'axe de référence supérieure à R_{cible} telle que le substrat soit disposé hors du plasma;
- la cible (9) et le porte-substrat (10) sont disposés l'un en face de l'autre.

2. Dispositif selon la revendication précédente, dans lequel l'écran (8) est constitué d'un matériau amagnétique.

3. Dispositif selon l'une des revendications précédentes, dans lequel l'écran (8) est constitué d'un matériau conducteur électriquement.

4. Dispositif selon l'une des revendications précédentes, comportant un substrat en matériau organique disposé sur le porte-substrat (10).

5. Dispositif selon l'une des revendications précédentes, dans lequel la cible est disposée dans une zone du miroir de confinement (15) au niveau de laquelle le champ magnétique B est minimum.

## Patentansprüche

1. Vorrichtung für die Herstellung einer Schicht aus amorphem Kohlenstoff per Plasma mit elektronischer Zyklotronresonanz, wobei die Vorrichtung umfasst:
- eine Plasmakammer (3);
- Zuführmittel eines Gases (4) in die Plasmakammer (3);
- einen magnetischen Spiegel (15) zur Einschließung,
- eine Wellenführung (5), die in die Plasmakammer (3) eingeführt ist, wobei die Wellenführung (5) sich gemäß einer Referenzachse (14) erstreckt;
- Einspritzmittel (1) einer elektromagnetischen Mikrowellen-Welle, die zum Einspritzen einer elektromagnetischen Mikrowellen-Welle in die Plasmakammer (3) mithilfe der Wellenführung (5) angeordnet sind;
- Erzeugungsmittel (2) eines Magnetfeldes in der Plasmakammer (3), wobei die Einspritzmittel (1) und die Erzeugungsmittel (2) zum Bilden eines elektronischen Zyklotronresonanz-Bereichs (6) in der Plasmakammer (3) ausgestaltet sind, wobei die Erzeugungsmittel (2) des magnetischen Feldes darüber hinaus zum Schaffen eines Strahlenbündels (13) von magnetischen Feldlinien ausgestaltet sind, an denen entlang ein Plasma verteilt ist, wobei sich das Plasma gemäß der Referenzachse (14) erstreckt, wobei das Plasma einen Rand aufweist;
- ein Ziel (9) aus zu versprühendem Kohlenstoff;
- einen Substratträger (10), der zum Tragen eines Substrats angeordnet ist;
**dadurch gekennzeichnet, dass**
- das Ziel (9) parallel zur Referenzachse und in einer Entfernung zur Referenzachse angeordnet ist, die zwischen R_{cible}/2 und R_{cible} inbegriffen ist, wobei R_{cible} die Entfernung zwischen dem Rand des Plasmas und der Referenzachse am Ziel ist und dass
- die Vorrichtung darüber hinaus einen Schirm (8) umfasst, der zwischen der Wellenführung (5) und dem Substratträger (10) angeordnet ist, wobei der Schirm (8) sich lotrecht zur Referenzachse (14) erstreckt und die Plasmapartikel, die auf das Substrat einwirken können, örtlich zurückhalten kann;
- der Substratträger (10) parallel zur Referenzachse (14) und in einer Entfernung zur Referenzachse von mehr als R_{cible} derart angeordnet ist, dass das Substrat außerhalb des Plasmas angeordnet ist;
- das Ziel (9) und der Substratträger (10) einander gegenüber angeordnet sind.

2. Vorrichtung gemäß dem voranstehenden Anspruch, bei der der Schirm (8) aus einem nicht magnetischen Material gebildet ist.

3. Vorrichtung gemäß einem der voranstehenden Ansprüche, bei der der Schirm (8) aus einem elektrisch leitenden Material gebildet ist.

4. Vorrichtung gemäß einem der voranstehenden Ansprüche, umfassend ein Substrat aus organischem Material, das auf dem Substratträger (10) angeordnet ist.

5. Vorrichtung gemäß einem der voranstehenden Ansprüche, bei der das Ziel in einem Bereich des Einschließungsspiegels (15) angeordnet ist, in dem das magnetische Feld B im Minimum ist.

## Claims

1. Device for producing an amorphous carbon layer by electron cyclotron resonance plasma, the device comprising:
- a plasma chamber (3);
- means for conveying a gas (4) into the plasma chamber (3),
- a magnetic confinement mirror (15),
- a waveguide (5) inserted into the plasma chamber (3), the waveguide (5) extending along a reference axis (14);
- means (1) for injecting a microwave electromagnetic wave arranged to inject a microwave electromagnetic wave into the plasma chamber (3) by means of the waveguide (5);
- means (2) for generating a magnetic field in the plasma chamber (3), the injection means (1) and the generating means (2) being configured to form an electron cyclotron resonance zone (6) in the plasma chamber (3), the means (2) for generating the magnetic field being further configured to create a beam (13) of magnetic field lines along which plasma is diffused, the plasma extending along the reference axis (14), the plasma having an edge;
- a target (9) made from carbon to be sputtered;
- a substrate holder (10) arranged to hold a substrate;
**Characterised in that**:
- the target (9) is arranged parallel to the reference axis and at a distance from the reference axis of between R_{target}/2 and R_{target}, where R_{target} is the distance, at the level of the target, between the edge of the plasma and the reference axis, and **in that**
- the device further comprises a screen (8) arranged between the waveguide (5) and the substrate holder (10), the screen (8) extending perpendicularly to the reference axis (14) and locally stopping plasma particles capable of impacting the substrate;
- the substrate holder (10) is arranged parallel to the reference axis (14) and at a distance from the reference axis greater than R_{target} such that the substrate is arranged outside of the plasma;
- the target (9) and the substrate holder (10) are arranged facing each other.

2. Device according to the preceding claim, in which the screen (8) is constituted of a non-magnetic material.

3. Device according to one of the preceding claims, in which the screen (8) is constituted of an electrically conductive material.

4. Device according to one of the preceding claims, comprising a substrate made from organic material arranged on the substrate holder (10).

5. Device according to one of the preceding claims, in which the target is arranged in a zone of the confinement mirror (15) at the level of which the magnetic field B is minimum.
